# EUROPÄISCHE PATENTANMELDUNG

(11) **EP 1 420 383 A2**
(43) Veröffentlichungstag der Anmeldung: **19.05.2004**
(21) Anmeldenummer: 03025985.7
(22) Anmeldetag: 13.11.2003
(51) Int. Cl.: G09F 23/00, G09F 13/00

(54) **Leiterplatte mit Anzeigeelement**

(30) Priorität: 15.11.2002 DE 10253420
(71) Anmelder: HONEYWELL B.V., 1101 EA Amsterdam Z.O. (NL)
(72) Erfinder: Bosscher, Eric, 7957DH De Wijk (NL)
(74) Vertreter: Leson, Thomas Johannes Alois, Dipl.-Ing.

(57) **Zusammenfassung**

Gezeigt wird eine Leiterplatte mit einer nicht leitfähigen Tragplatte aus lichtdurchlässigem Material, einer auf der Tragplatte angeordneten leitfähigen Schicht aus lichtundurchlässigen Material und einer an der Tragplatte angeordneten Lichtquelle, wobei in der leitfähigen Schicht eine Information repräsentierende Aussparung vorgesehen ist und wobei die Lichtquelle derart angeordnet ist, dass sie die Aussparung beleuchtet.

## Beschreibung

Die Erfindung bezieht sich auf eine Leiterplatte, die ein Element zum Anzeigen von Informationen umfasst.

Leiterplatten sind in einer Vielzahl von unterschiedlichen Ausführungen bekannt. Im Allgemeinen bestehen sie aus einer nicht leitenden Tragplatte, die auf einer oder beiden Seiten mit Leiterbahnen versehen ist. Diese Leiterplatten werden dann mit Bauelementen bestückt und in einem bestimmten Gerät ihrem Zweck zugeführt.

Die Leiterplatte ist vor Herstellung der Leiterbahnen mit einer durchgehenden Kupferschicht bedeckt. Auf diese Kupferschicht wir nun ein Bild der gewünschten Leiterbahn mit einem säurefesten Aufzeichnungsmaterial aufgebracht. In einem darauffolgenden Ätzschritt wird dann das nicht zur Leiterbahn gehörige Kupfer entfernt und die fertige Leiterplatte kann, nach einer Entfernung des säurefesten Aufzeichnungsmaterials bestückt werden.

Bei dieser Bestückung kann beispielsweise auf der Leiterplatte eine Anzeigeeinrichtung angeordnet und mit einer entsprechenden Steuereinrichtung, die ebenfalls auf der Leiterplatte ausgebildet sein kann, angesteuert werden. Solche Anzeigeeinrichtungen umfassen im allgemeinen ein Matrixanzeigefeld, bei dem die Matrixelemente einzeln angesteuert werden können.

In einigen Fällen ist jedoch die Vorsehung einer solchen Anzeigeeinrichtung zu aufwändig.

Der Erfindung liegt die Aufgabe zugrunde, eine Leiterplatte in einfacher Art und Weise mit einer Anzeigemöglichkeit auszustatten.

Diese Aufgabe wird durch eine Leiterplatte mit den im Patentanspruch 1 angegebenen Merkmalen auf besonders vorteilhafte Art und Weise gelöst.

Die Leiterplatte umfasst eine nicht leitende Tragplatte aus lichtdurchlässigem Material, eine auf der Tragplatte angeordnete leitfähige Schicht aus lichtundurchlässigem Material und eine an der Tragplatte angeordnete Lichtquelle. In der leitfähigen Schicht sind Aussparungen vorgesehen, die Informationen repräsentieren, wie beispielsweise Buchstaben, Zahlen oder Symbole. Die Lichtquelle ist derart angeordnet, dass sie die Aussparung beleuchtet.

Auf diese Art und Weise kann die der Aussparung entsprechende Information zur Anzeige gebracht werden. Eine separate Anzeigeeinrichtung ist hierfür nicht erforderlich. Dies ist insbesondere dann von großem Vorteil, wenn Symbole angezeigt werden sollen, deren Gestalt so kompliziert ist, dass sie einer aufwändigen Anzeigeeinrichtung bedürfen.

Von besonderem Vorteil ist dabei, dass die Herstellung einer solchen Leiterplatte mit Anzeigeelement keine Herstellungsschritte oder Herstellungswerkzeuge erfordert, die nicht bereits für die Herstellung einer normalen Leiterplatte erforderlich werden. Auch sind keine speziellen Bauteile zum Erzielen der Funktion einer Anzeige erforderlich. Die mit der Anzeigefunktion versehene Leiterplatte kann somit mehr oder weniger mit denselben Kosten hergestellt werden, wie eine normale Leiterplatte. Jedoch entfällt der zusätzliche materielle und kostenmäßige Aufwand für eine separate Anzeigeeinrichtung.

An der Leiterplatte können eine Mehrzahl von Lichtquellen und eine Mehrzahl von Aussparungen vorgesehen sein. In diesem Fall kann die Mehrzahl von Aussparungen unterschiedliche Informationen repräsentieren. Sinnvollerweise wird dabei jeder Informationen repräsentierenden Aussparung zumindest eine Lichtquelle zugeordnet. Die Mehrzahl der Lichtquellen soll einzeln ansteuerbar sein, wobei selbstverständlich eine gruppenweise Ansteuerung mehrerer Lichtquellen möglich ist.

Durch diese Merkmale wird auch eine etwas komplexere Anzeigeeinrichtung ermöglicht, wie beispielsweise eine Sieben-Segment-Anzeige oder aber die gleichzeitige Anzeigemöglichkeit für eine Mehrzahl von unterschiedlichen Symbolen.

Sind die Lichtquelle und die leitfähige Schicht auf gegenüberliegenden Seiten der Tragplatte angeordnet, ergibt sich durch die Dicke der Tragplatte ein für die Anzeigequalität vorteilhafter Abstand zwischen der Lichtquelle und der durch die Aussparung gebildeten Maske.

Durch die Verwendung eines Reflektors kann das Licht einer Lichtquelle auf gewünschte Art und Weise auf die Aussparung gerichtet werden. Auch hierdurch lassen sich unterschiedliche Anzeigeeffekte erreichen.

Die auf der Tragplatte vorgesehene leitfähige Schicht kann nun entweder ausschließlich zur Bildung einer Maske für vorbestimmte Informationsinhalte oder aber ausschließlich als leitfähig Schicht oder aber für Beides gleichzeitig verwendet werden. Dies ermöglicht eine Vielzahl von Möglichkeiten bei der Gestaltung der Leiterplatte hinsichtlich der Anordnung der Bauteile.

Die Erfindung wird nachfolgend anhand der Figuren näher erläutert.

Die Figur 1 zeigt eine Schnittdarstellung einer mit einer Anzeigefunktion ausgestatteten Leiterplatte.

Die Figur 2 zeigt eine Schnittdarstellung einer mit einer Anzeigefunktion ausgestatteten Leiterplatte die einen Reflektor verwendet.

Die Figur 3 zeigt ein Beispiel für eine Leiterplatte, auf der eine Vielzahl von Informationen angeordnet sind.

In den Figuren ist mit 1 eine Tragplatte, mit 2 eine leitfähige Schicht, mit 3 eine Lichtquelle und mit 4 ein Reflektor bezeichnet.

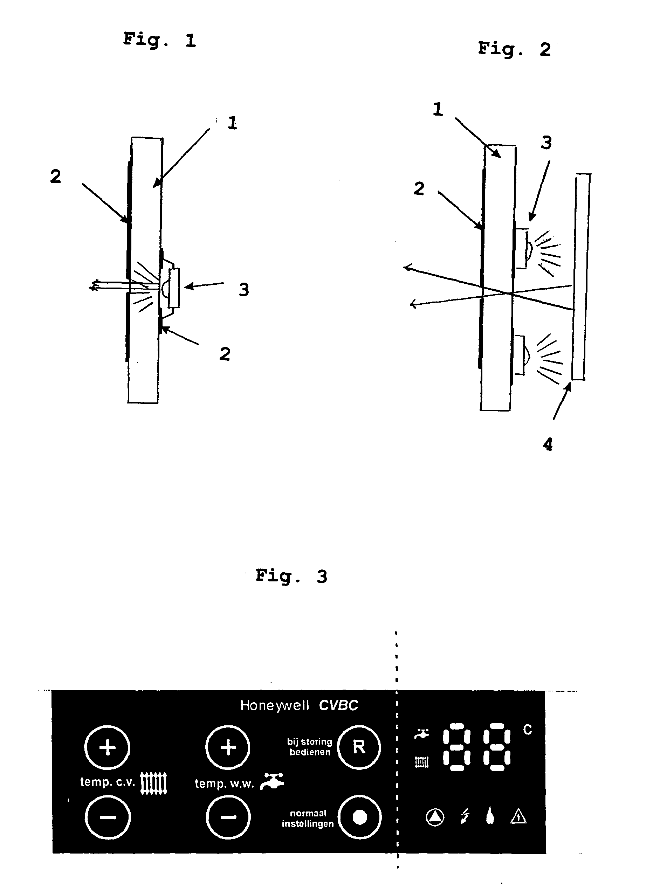

Die in der Figur 1 gezeigte Leiterplatte umfasst die Tragplatte 1 und auf beiden Seiten Leiterbahnen in Form der leitfähigen Schichten 2. Eine Lichtquelle 3 ist an der Leiterplatte durch Verlötung mit den Leiterbahnen 2 angeordnet.

Die Tragplatte 1 besteht aus lichtdurchlässigem Material wie beispielsweise aus glasfasergefülltem Epoxidharz.

Die Leiterbahnen in Form der leitfähigen Schichten 2 bestehen vorzugsweise aus Kupfer.

Als Lichtquelle 3 eignen sich herkömmliche Leuchtdioden. Am einfachsten ist es, wenn diese mit Leiterbahnen der Leiterplatte verlötet sind. Es ist jedoch auch eine Anordnung der Lichtquellen unabhängig von der Leiterplatte möglich, beispielsweise an einem zu der Leiterplatte benachbarten Gehäuseelement. In jedem Fall ist die Lichtquelle so anzuordnen, dass ihr Licht durch die Aussparung tritt.

Als Reflektor 4 ist jedes erdenkliche Element, das zur Reflektion von Lichtstrahlen geeignet ist, verwendbar. Über die in der Figur 2 gezeigte Form hinaus sind andere Reflektorformen je nach gewünschter Anzeigeart einsetzbar.

Die Lichtquelle 3 ist im allgemeinen einfarbig. Gerade aber bei der Anordnung nach Figur 2 können die zwei dort gezeigten Lichtquellen von unterschiedlicher Farbe sein und jeweils unterschiedlich angesteuert werden, so dass ein und dieselbe Information entweder rot oder gelb zur Anzeige gebracht werden kann.

Vorteilhafterweise sind die Lichtquelle 3 und die Aussparungen 2 auf unterschiedlichen Seiten der Leiterplatte angeordnet. Es ist zur Erzielung optischer Anzeigeeffekte oder bei konstruktiv-/räumlicher Notwendigkeiten auch möglich, beide Elemente auf derselben Seite anzuordnen.

Der Figur 3 lassen sich schließlich noch eine Vielzahl von Möglichkeiten entnehmen, wie die aus der leitfähigen Schicht 2 ausgesparte Information beschaffen sein. Die dort vorgesehenen Elemente können alle einzeln hinterleuchtet werden.

## Patentansprüche

1. Leiterplatte mit
einer nicht leitenden Tragplatte (1) aus lichtdurchlässigem Material,
einer auf der Tragplatte angeordneten leitfähigen Schicht (2) aus lichtundurchlässigem Material und
einer an der Tragplatte angeordneten Lichtquelle (3),
wobei in der leitfähigen Schicht eine Informationen repräsentierende Aussparung vorgesehen ist und
wobei die Lichtquelle derart angeordnet ist, dass sie die Aussparung beleuchtet.

2. Leiterplatte nach Anspruch 1, **dadurch gekennzeichnet,**
**dass** eine Mehrzahl von Lichtquellen und eine Mehrzahl von Aussparungen vorgesehen sind,
wobei die Mehrzahl von Aussparungen unterschiedliche Informationen repräsentieren,
wobei allen Informationen repräsentierenden Aussparungen zumindest eine Lichtquelle zugeordnet ist und
wobei die Mehrzahl der Lichtquellen einzeln steuerbar ist.

3. Leiterplatte nach Anspruch 1, **dadurch gekennzeichnet,**
**dass** die Lichtquelle und die leitfähige Schicht auf gegenüberliegenden Seiten der Tragplatte angeordnet sind.

4. Leiterplatte nach Anspruch 1, **dadurch gekennzeichnet,**
**dass** ein Reflektor (4) vorgesehen ist, mit dem das Licht der Lichtquelle auf die Aussparung gerichtet wird.

5. Leiterplatte nach Anspruch 1, **dadurch gekennzeichnet,**
**dass** eine Vielzahl elektronischer Bauteile auf einer oder beiden Seiten der Tragplatte angeordnet sind.

6. Leiterplatte nach Anspruch 1, **dadurch gekennzeichnet,**
**dass** die leitfähige Schicht gleichzeitig auch als Leiterbahn verwendet wird, und aus Kupfer besteht,
wobei die Leiterbahnen und die Informationen repräsentierende Aussparung in einem Schritt durch Ätzen hergestellt wird.

7. Leiterplatte nach Anspruch 1, **dadurch gekennzeichnet,**
**dass** auf beiden Seiten der Tragplatte leitfähige Schichten vorgesehen sind, die entweder zur Ausbildung von Leiterbahnen oder zur Umgrenzung von Informationen repräsentierenden Aussparungen die Tragplatte teilweise bedecken.

8. Leiterplatte nach Anspruch 1, **dadurch gekennzeichnet,**
**dass** die Informationen Symbole, Buchstaben, Zahlen oder geometrische Elemente umfassen.

9. Anzeigeeinrichtung mit einer Leiterplatte nach einem der vorhergehenden Ansprüche.
